# EUROPEAN PATENT SPECIFICATION

(11) **EP 3 732 700 B1**
(45) Date of publication and mention of the grant of the patent: **06.09.2023**
(21) Application number: 18897636.9
(22) Date of filing: 26.12.2018
(51) Int. Cl.: H03K 17/28, H03K 17/16, H01H 9/56, H01H 9/00, H01H 9/54, H03K 17/56

(54) **AC MOTOR SOLID STATE SWITCH CONTROL**
FESTKÖRPERSCHALTTEUERUNG FÜR WECHSELSTROMMOTOR
COMMANDE DE COMMUTATEUR À SEMI-CONDUCTEURS POUR MOTEUR À COURANT ALTERNATIF

(30) Priority: 28.12.2017 US 201762611142 P
(43) Date of publication of application: 04.11.2020
(73) Proprietor: ABB Schweiz AG, 5400 Baden (CH)
(72) Inventor: BATOR, Matthias, 79771 Klettgau, Baden-Wurttemberg (DE); CAIROLI, Pietro, Cary, NC 27511 (US); CARR, Joseph, Raleigh, NC 27606 (US)
(74) Representative: Maiwald GmbH
(86) International application number: PCT/US2018/067508
(87) International publication number: WO 2019/133612

(56) References cited:
- WO-A1-2012/142082
- US-A- 4 356 525
- US-A- 4 356 525
- US-A1- 2005 052 808
- US-A1- 2012 038 310
- US-B2- 8 456 117

## Description

### BACKGROUND

The present inventions relate generally to AC motors, and more particularly, to the control of a switch to turn on an AC motor.

AC motors are typically provided with one or more switches that connect the motor to the AC power supply of an AC electrical grid. When connected to the AC electrical grid, the AC motor may be referred to as being Direct on Line (DOL). The switches used to connect the motor to the grid are often referred to as contactors since they must be capable of handling the full voltage and current load of the motor.

Often, conventional contactors are electromechanical switches which use an electromagnetic actuator and a mechanical switch to turn power on and off to an AC motor. One advantage of electromechanical switches is their high durability to electrical loads passing through the switch. Although electromechanical switches typically have a relatively slow reaction time, this is not always a problem for electrical motor contactors since the timing of turning the motor on and off is not always critical.

Solid state switches are sometimes used in place of electromechanical switches in electrical motor contactors. There are various advantages of solid state switches which are understood in the art. However, solid state switches do not always have the same durability to high loads passing therethrough. Thus, if the current and/or voltage passing through a solid state switch exceeds the design limits of the switch, the switch may prematurely fail. Alternatively, where it is possible that high currents and/or voltages may at least occasionally pass through the switch during use, it may be desirable to oversize the switch to avoid switch failures. However, this has the disadvantage of increasing costs and size of the contactors.

US 4 356 525 A concerns a method and circuit for minimizing DC current offset generated by the voltage-integrating property of an inductive load. First, second and third hybrid contactors connect first, second, and third output lines of an AC power source to first, second, and third input lines of an inductive load. Each hybrid contactor includes a pair of relay contacts in parallel with a semiconductor switching unit having two antiparallel-connected silicon-controlled-rectifiers. A latching circuit and several delay circuits are used to turn on and off the hybrid contactors. The timing of the turn-on points is controlled relative to a zero-crossing of a voltage from the AC power source such that minimal DC offset current occurs.

### SUMMARY

The invention concerns a method of controlling an AC electrical motor according to claim 1. Further aspects of the present invention are defined in the dependent claims. An improved method of starting an AC motor is described. In the method, a switch controller receives a control signal to turn the motor on. The switch controller then monitors a waveform of the AC power supply and delays closing the power switch until the waveform reaches a predetermined state. As a result, the switch controller reduces initial inrush current flowing through the power switch which could damage a solid state switch.

### BRIEF DESCRIPTION OF SEVERAL VIEWS OF THE DRAWINGS

The invention may be more fully understood by reading the following description in conjunction with the drawings, in which:
Figure 1 is a schematic view of an AC electrical motor and an AC power supply grid;
Figure 2A is a chart of AC current flow to the motor;
Figure 2B is a chart showing an improved AC current flow to the motor;
Figure 3A is a chart showing three phase voltage of the AC power supply grid;
Figure 3B is a chart showing three phase current supplied to the motor;
Figure 3C is a chart showing the rotor flux vector of the motor based on the voltage and current of Figures 3A and 3B;
Figure 4A is a chart showing three phase voltage of the AC power supply grid;
Figure 4B is a chart showing improved three phase current supplied to the motor;
Figure 4C is a chart showing the improved rotor flux vector of the motor based on the voltage and current of Figures 4A and 4B; and
Figure 5 is a flow chart of a method of controlling the motor.

### DETAILED DESCRIPTION

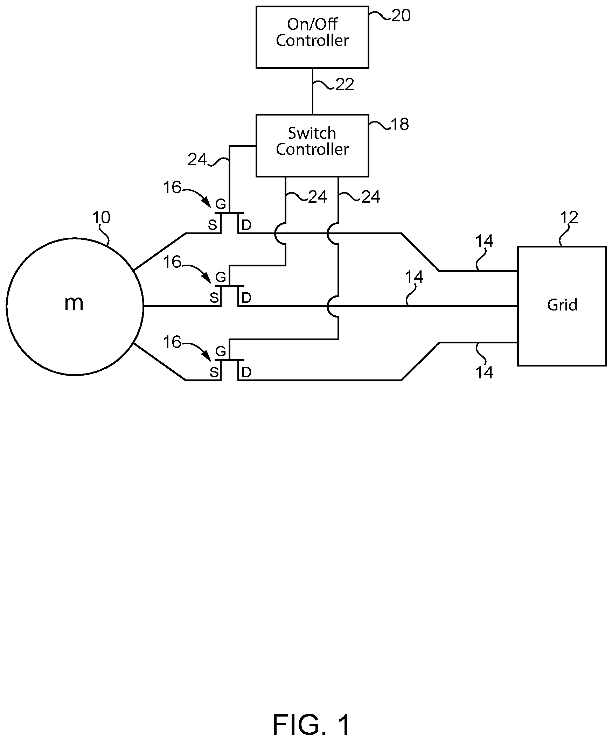

Referring now to the figures, and particularly Figure 1, a schematic of a motor 10 connected to an AC power supply grid 12 is shown. Although the motor 10 may be supplied with single phase power, the motor 10 in Figure 1 is shown connected to the electrical grid 12 with three phase power 14. As shown, each power line 14 between the grid 12 and motor 10 is provided with a switch 16 which interrupts and connects the power supply between the grid 12 and the motor 10. Although Figure 1 illustrates a single switch 16 being used in each power line 14, it is understood that each switch 16 may represent multiple switches, for example a switch bank, to perform the required switching between the AC electrical grid 12 and the motor 10.

In the preferred embodiment, the switches 16 are solid state switches 16 as distinguished from electromechanical switches. The switches 16 may be known as electrical motor contactors 16 since the switches 16 must be capable of handling the full load of power supplied to the motor 10 from the grid 12 or other AC power supply. As understood, solid state switches 16 typically have a source S and a drain D. A control signal 24 applied to the gate G of each switch 16 connects and disconnects power flowing through the source S and drain D. A switch controller 18 is provided for supplying control signals 24 to the gates G of the switches 16. Further, an on/off controller 20 is provided for turning the motor 10 on and off. That is, when it is desired to turn the motor 10 on, the on/off controller 20 sends a first control signal 22 to the switch controller 18. The switch controller 18 then responds to the on/off controller 20 by sending second control signals 24 to the gates G of the switches 16 to connect the respective sources S and drains D to permit electrical power to flow to the motor 10. When it is desired to turn the motor 10 off, the on/off controller 20 sends a corresponding first control signal 22 to the switch controller 18 which corresponds in a like manner with a second control signal 24 to disconnect the sources S and drains D. In conventional motors 10, it is possible to eliminate the switch controller 18 if the switches 16 are intended to directly respond to the on/off controller 20 without additional switch control. Although the on/off controller 20 may take various forms, in the simplest version the on/off controller 20 may be a manual switch actuated by a human operator. However, the on/off controller 20 may also be a computerized or other electrical controller if desired.

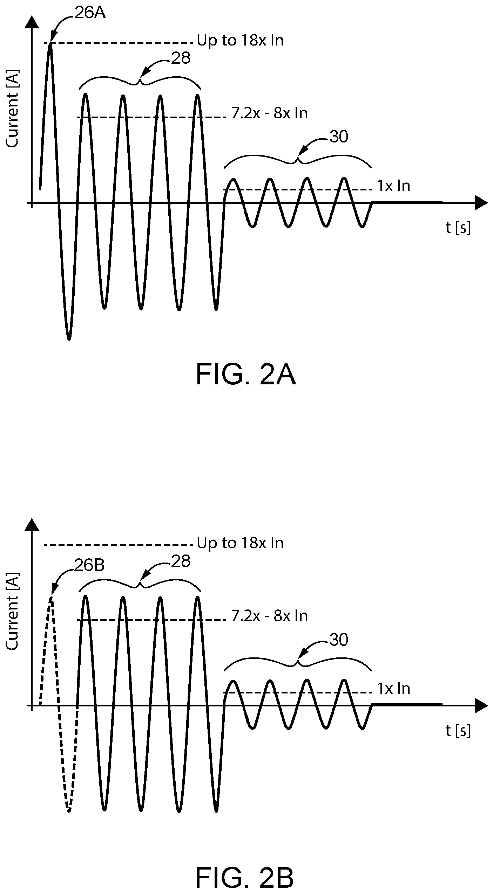

Turning to Figure 2A, current flow through the switches 16 is shown when the switches 16 are closed to turn the motor 10 on. As shown, the current flow through the switches 16 can be characterized by three stages 26A, 28, 30. The first stage 26A involves the initial inrush of current into the motor 10. The inrush of current 26A provides the initial magnetization of the motor 10. As shown, the inrush spike 26A in current may last as short as the very first AC cycle and diminishes shortly thereafter, possibly even in the second AC cycle. As noted in Figure 2A, the magnitude of the initial inrush of current 26A can be as high as 18 times the nominal current (In) 30 of the motor 10. In this particular scenario, the inrush current 26A is representative of an electrical motor 10 with an efficiency rating of at least 85 percent. The initial spike in inrush current 26A is particularly prominent in high efficiency motors 10 due to less electrical impedance and other factors. By comparison, in less efficient AC motors, the initial inrush current 26A may be only 12 times the nominal current (In) 30 of the motor 10.

After the initial inrush of current 26A is complete, the current 28 flowing through the switches 16 remains elevated but at a lower magnitude. This stage 28 involves accelerating the motor 10 from standstill to rated speed. Thus, greater current flow 28 is required to overcome the inertia of the motor 10 and accelerate the rotor up to the desired speed. As shown in Figure 2A, the magnitude of the starting current 28 is typically in the range of 7.2 to 8 times the nominal current (In) 30. Further, the starting current flow 28 typically lasts longer than the inrush current 26 and can last four or more AC cycles. Once the motor 10 reaches the rated or desired speed, the current flow transitions to the nominal current 30 (i.e., 1 times nominal current (In)).

In Figure 2B, current flow is shown for an improved method of starting an AC motor 10. As shown, the initial inrush current 26B can be minimized substantially from the inrush current 26A of Figure 2A. Preferably, the improved inrush current 26B is minimized to no more than 10 times, and more preferably 8 times, the nominal current (In) 30. Thus, the inrush current 26B is not substantially greater than the starting current 28 required to accelerate the motor 10 up to the rated speed. Although the length of the inrush current 26 can be extremely short (e.g., a single AC cycle), such an improvement could provide a significant increase in the robustness of the solid state switches 16, which can be adversely affected by even short spikes in current flowing therethrough.

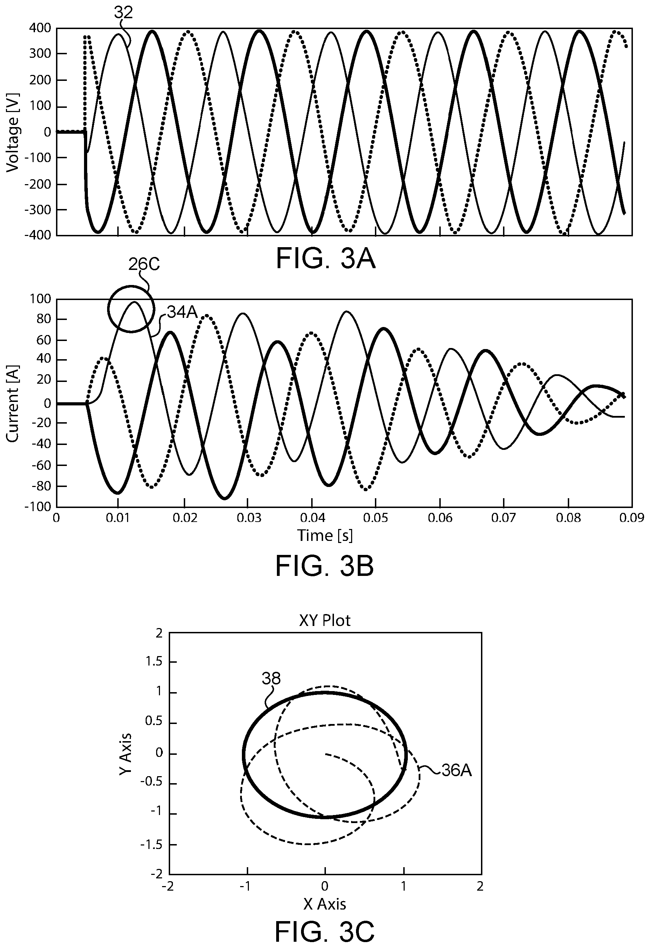

Figures 3A-3C illustrate voltages 32, currents 34A and rotor flux 36A in a conventional motor starting method as more generally shown in Figure 2A.
Figure 3A illustrates a voltage waveform 32 of three phase electrical power from an AC electrical grid 12. Figure 3B illustrates three phase currents 34A flowing through the switches 16 immediately after the motor 10 has been turned on and the switches 16 have been closed. As indicated by the circled peak 26C, one of the phase currents reaches a peak 26C having a magnitude substantially higher than the remaining current peaks. As noted above, this represents the higher inrush current 26C that can last as little as one AC cycle. As further shown, in a three phase motor 10, the higher inrush current 26C may affect only one of the phases, with the other two phases not experiencing especially high inrush currents. Thus, the high inrush current 26C may affect only one of the switches 16 in a three phase motor 10.
However, it is not typically possible to predict which switch 16 will be affected by a high inrush current 26C, and the switch 16 that experiences a high inrush current 26C is likely to randomly change with different startups of the motor 10.

The rotor flux vector 36A corresponding to Figure 3B is shown in Figure 3C. A design circle 38 is drawn on the chart illustrating the boundary of 100% of designed flux 38. Thus, in the chart, regions of the actual flux vector 36A that are outside of the design circle 38 represents states of saturated rotor flux. This is generally undesirable since current will continue to flow through the motor coils at a particular voltage without generating additional flux. However, as shown in Figure 3C, the illustrated current flows 34A result in substantial states of saturated rotor flux.

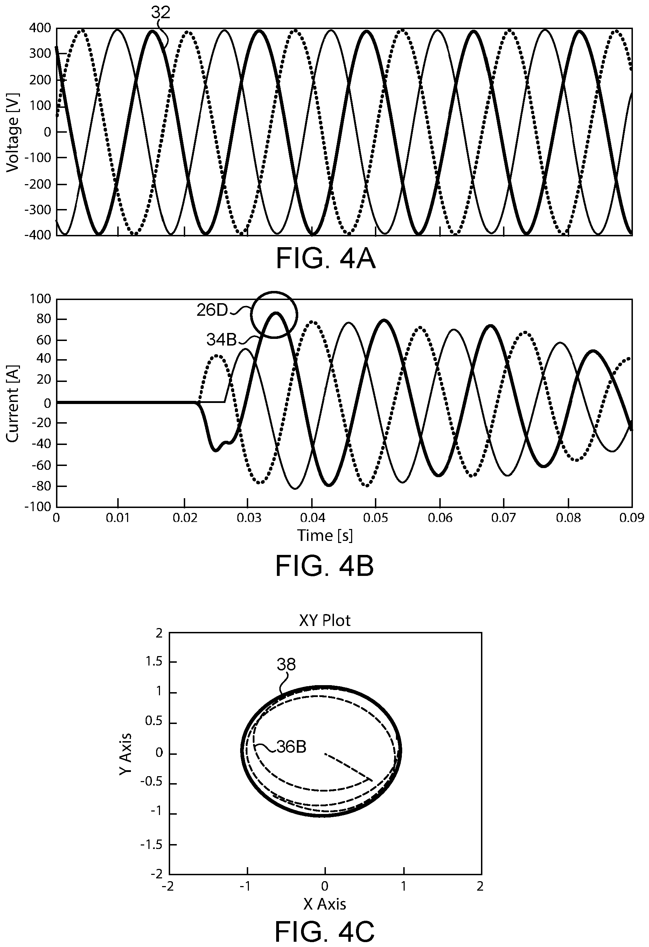

Turning to Figures 4A-4C similar voltage 32, current 34B and rotor flux 36B charts are shown for an improved motor starting method as more generally shown in Figure 2B. Like Figure 3A, Figure 4A illustrates the voltage waveform 32 of three phase electrical power from an AC electrical grid 12. Figure 4B illustrates three phase currents 34B flowing through the switches 16 immediately after the motor 10 has been turned on by the switches 16. Like Figure 3B, the peak inrush current 26D is circled in Figure 4B for reference. As shown, the peak inrush current 26D in Figure 4B is less than the peak inrush current 26C in Figure 3B. Although the peak inrush current 26D in Figure 4B remains greater than the remaining current peaks, the difference between the peak inrush current 26D and the remaining peaks has been reduced. Thus, the solid-state switches 16 may be reduced in size, the longevity of the switches 16 increased, or other advantages accrued. Likewise, the rotor flux vector 36B is also improved. In particular, in Figure 4C the actual rotor flux 36B remains almost completely within the 100% design circle 38, meaning that there is minimum oversaturation of the flux.

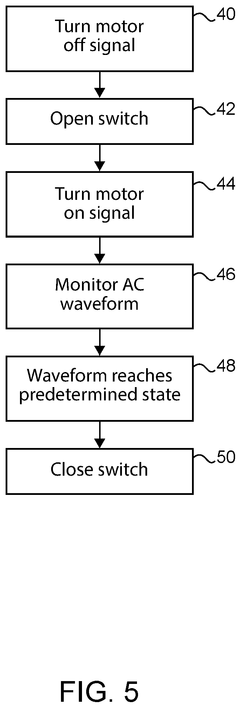

Turning to Figure 5, a flowchart of the method of starting the AC motor 10 to minimize inrush currents 26 is shown. In the method, the motor 10 begins in the off state with the motor 10 being disconnected from the AC power supply 12. That is, the on/off controller 20 has sent a first control signal 22 to the switch controller 18 to turn off the motor 10 (40). In response, the switch controller 18 sends a second control signal 24 to the switches 16 to open the switches 16 (42). As a result, the power lines 14 to the motor 10 are disconnected and rotation of the motor 10 stops.

Thereafter, when it is desired to turn on the motor 10 to cause rotation thereof, the on/off controller sends a first control signal 22 to the switch controller 18 to turn on the motor 10 (44). Instead of immediately closing switches 16, the switch controller 18 then monitors the waveform of the AC power supply 12 and waits for the waveform to reach a predetermined state (46). Thus, the switch controller 18 delays closing the switches 16 after the first control signal 22 is received from the on/off controller 20.

Although the delay period and predetermined state may be chosen for the particular application, in the preferred embodiment the switch controller 18 monitors the voltage supply waveform for a zero crossing where the sinusoidal AC waveform reaches zero voltage (i.e., crosses from a positive to negative voltage or vice versa) (46). Upon identifying a zero crossing of the voltage waveform, the switch controller 18 then preferably waits for a particular time delay before sending a second control signal 24 to the switches to close (48). In particular, a time delay of between 25% and 75% of a half cycle of the waveform may be a desirable time delay. The switch controller 18 then sends a second control signal 24 to the switches 16 to close, which connects the power supply 12 to the motor 10 and causes the motor 10 to begin to rotate (50).

As a result, the switch controller 18 prevents the first full waveform from passing through the switch 16. Thus, the first waveform that could have passed through the switch 16 based on the timing of the on/off controller 20 only partially passes through the switch 16. As a result, initial current flow through the switch 16 may be limited. Where three phase power is supplied to the motor 10 as illustrated Figure 1, it is preferred for the switch controller 18 to monitor each of the phase waveforms. Where the monitoring involves monitoring for a zero crossing and the predetermined state involves a time delay after the zero crossing, it is preferred that these conditions are applied to each of the phases and switches 16 independently. That is, since each of the phases will cross zero at different times, the switches 16 for each phase may also be closed at different times. Thus, where the waveforms for each phase are offset from each other by a particular ratio or timing, the switches 16 could be closed by the switch controller 18 by the same phase offset timing. Therefore, unlike a conventional control where all the switches are immediately closed at the same time when a control signal is received to turn on the motor, the described method involves closing switches 16 at different times (e.g., as determined by the phase offset) and delaying each switch 16 to prevent a full first waveform from passing through the switch 16.

It is also possible that the described method could be used over multiple initial waveforms if desired to further moderate the inrush current. For example, after the switch 16 has been closed following the time delay, the switch 16 could be reopened before the second waveform passes through the switch 16. This may occur at a zero crossing. The switch controller 18 may then monitor the second waveform in a similar manner as described above before closing the switch 16 again during the second waveform to prevent the second full waveform from passing through the switch 16. It may also be desirable for the time delay in closing the switch 16 to be more during the first waveform and less in subsequent waveforms. For example, during the first waveform the time delay may be 75%; during the second waveform the time delay may be 50%; during the third waveform the time delay may be 25%; and thereafter the switch 16 may remain closed. Thus, each subsequent waveform passes more current through the switch 16. Preferably, the reopening, delaying, and closing of the switch 16 is completed within 10 or fewer waveforms so that thereafter the switch 16 remains closed during subsequent waveforms.

The scope of the inventions is defined by the appended claims, and all devices and methods that come within the meaning of the claims, either literally or by equivalence, are intended to be embraced therein.

## Claims

1. A method of controlling an AC electrical motor (10), comprising:
opening a solid-state switch (16) coupled between an AC power supply (12) and the AC electrical motor (10), the AC power supply (12) supplying AC electrical power to the AC electrical motor (10) to rotate the AC electrical motor (10) when the solid-state switch (16) is closed, and the AC power supply (12) being disconnected from the AC electrical motor (10) to stop rotation of the AC electrical motor (10) when the solid-state switch (16) is opened;
receiving a first control signal to turn on the AC electrical motor (10);
monitoring a waveform of the AC electrical power supplied by the AC power supply (12),
wherein the waveform is a first waveform;
delaying closing the solid-state switch after receiving the first control signal until the waveform of the AC electrical power reaches a predetermined state,
wherein the predetermined state is a first predetermined state;
sending a second control signal to close the solid-state switch (16) after the waveform of the AC electrical power reaches the first predetermined state;
sending a third control signal to reopen the solid state switch after the second control signal has been sent;
monitoring a second waveform of the AC electrical power supplied by the AC power supply (12); and
delaying closing the solid state switch (16) until the second waveform of the AC electrical power reaches a second predetermined state,
wherein the first and second predetermined states are different from each other to allow greater current flow through the solid state switch during the second waveform than the first waveform.

2. The method according to claim 1, wherein the monitoring of the waveform comprises monitoring a zero crossing of the waveform.

3. The method according to claim 2, wherein the predetermined state is a time delay after the zero crossing of the waveform.

4. The method according to claim 3, wherein the time delay is between 25% and 75% of a half cycle of the waveform, preferably wherein the waveform is a voltage waveform.

5. The method according to claim 1, wherein the waveform is a voltage waveform.

6. The method according to claim 1, wherein the solid-state switch (16) is an electrical motor contactor.

7. The method according to claim 6, wherein current passing through the electrical motor contactor is limited in a first cycle of the waveform to 10 times a nominal running current of the AC electrical motor (10).

8. The method according to claim 1, wherein current passing through the solid-state switch (16) is limited in a first cycle of the waveform to 8 times a nominal running current of the AC electrical motor (10).

9. The method according to claim 1, wherein the AC power supply (12) is an AC electrical power grid; or
wherein the AC electrical motor (10) has an efficiency rating of at least 85%.

10. The method according to claim 1, wherein the AC electrical power comprises three phase power, and comprising at least one of the solid-state switch (16) for each phase, wherein closing the solid-state switch (16) for each phase is delayed until the waveform of the phase associated with each solid-state switch (16) reaches a predetermined state, and the second signal is sent to each solid-state switch after the waveform of the phase associated with each solid-state switch reaches the predetermined state, the second signal for each of the switches (16) being sent at different times relative to each other such that the solid-state switches (16) do not close at the same time.

11. The method according to claim 10, wherein the predetermined state is the same for each phase, each of the predetermined states being offset by the offset between the phases.

12. The method according to claim 11, wherein the monitoring of the waveform comprises monitoring a zero crossing of the waveform.

13. The method according to claim 12, wherein the predetermined state is a time delay after the zero crossing of the waveform, preferably wherein the time delay is between 25% and 75% of a half cycle of the waveform.

14. The method according to claim 1, further comprising:
sending a fourth control signal to close the solid-state switch after the second waveform of the AC electrical power reaches the second predetermined state.

15. The method according to claim 14,
wherein the solid-state switch (16) remains closed during subsequent waveforms after 10 or fewer waveforms.

## Patentansprüche

1. Verfahren zum Steuern eines Wechselstrom-Elektromotors (10), umfassend:
Öffnen eines Festkörperschalters (16), der zwischen einer Wechselstrom-Stromversorgung (12) und dem Wechselstrom-Elektromotor (10) gekoppelt ist, wobei die Wechselstrom-Stromversorgung (12) den Wechselstrom-Elektromotor (10) mit elektrischer Wechselstromleistung versorgt, um den Wechselstrom-Elektromotor (10) zu drehen, wenn der Festkörperschalter (16) geschlossen ist, und wobei die Wechselstrom-Stromversorgung (12) von dem Wechselstrom-Elektromotor (10) getrennt wird, um die Rotation des Wechselstrom-Elektromotors (10) zu stoppen, wenn der Festkörperschalter (16) geöffnet wird;
Empfangen eines ersten Steuersignals zum Einschalten des Wechselstrom-Elektromotors (10); Überwachen einer Wellenform der von der Wechselstromversorgung (12) gelieferten elektrischen Wechselstromleistung,
wobei die Wellenform eine erste Wellenform ist;
Verzögern des Schließens des Festkörperschalters nach dem Empfangen des ersten Steuersignals, bis die Wellenform der elektrischen Wechselstromleistung einen vorbestimmten Zustand erreicht,
wobei der vorbestimmte Zustand ein erster vorbestimmter Zustand ist;
Senden eines zweiten Steuersignals, um den Festkörperschalter (16) zu schließen, nachdem die Wellenform der elektrischen Wechselstromleistung den ersten vorbestimmten Zustand erreicht hat;
Senden eines dritten Steuersignals, um den Festkörperschalter wieder zu öffnen, nachdem das zweite Steuersignal gesendet wurde;
Überwachen einer zweiten Wellenform der von der elektrischen Stromversorgung (12) gelieferten elektrischen Wechselstromleistung; und
Verzögern des Schließens des Festkörperschalters (16), bis die zweite Wellenform der elektrischen Wechselstromleistung einen zweiten vorbestimmten Zustand erreicht,
wobei der erste und der zweite vorbestimmte Zustand voneinander verschieden sind, um einen größeren Stromfluss durch den Festkörperschalter während der zweiten Wellenform als bei der ersten Wellenform zu ermöglichen.

2. Verfahren nach Anspruch 1, wobei das Überwachen der Wellenform das Überwachen eines Nulldurchgangs der Wellenform umfasst.

3. Verfahren nach Anspruch 2, wobei der vorbestimmte Zustand eine Zeitverzögerung nach dem Nulldurchgang der Wellenform ist.

4. Verfahren nach Anspruch 3, wobei die Zeitverzögerung zwischen 25 % und 75 % eines Halbzyklus der Wellenform beträgt, wobei die Wellenform vorzugsweise eine Spannungswellenform ist.

5. Verfahren nach Anspruch 1, wobei die Wellenform eine Spannungswellenform ist.

6. Verfahren nach Anspruch 1, wobei der Festkörperschalter (16) ein elektrisches Motorschütz ist.

7. Verfahren nach Anspruch 6, wobei der durch das elektrische Motorschütz fließende Strom in einem ersten Zyklus der Wellenform auf das 10-fache des Nennbetriebsstroms des Wechselstrom-Elektromotors (10) begrenzt wird.

8. Verfahren nach Anspruch 1, wobei der durch den Festkörperschalter (16) fließende Strom in einem ersten Zyklus der Wellenform auf das 8-fache eines Nennbetriebsstroms des Wechselstrom-Elektromotors (10) begrenzt wird.

9. Verfahren nach Anspruch 1, wobei die Wechselstromversorgung (12) ein elektrisches Wechselstromleistungsnetz ist; oder
wobei der Wechselstrom-Elektromotor (10) einen Wirkungsgrad von mindestens 85 % aufweist.

10. Verfahren nach Anspruch 1, wobei die elektrische Wechselstromleistung einen Dreiphasenstrom umfasst und mindestens einen der Festkörperschalter (16) für jede Phase umfasst, wobei das Schließen des Festkörperschalters (16) für jede Phase verzögert wird, bis die Wellenform der Phase, die jedem Festkörperschalter (16) zugeordnet ist, einen vorbestimmten Zustand erreicht, und das zweite Signal an jeden Festkörperschalter gesendet wird, nachdem die Wellenform der Phase, die jedem Festkörperschalter zugeordnet ist, den vorbestimmten Zustand erreicht, wobei das zweite Signal für jeden der Schalter (16) zu unterschiedlichen Zeiten relativ zueinander gesendet wird, so dass die Festkörperschalter (16) nicht zur gleichen Zeit schließen.

11. Verfahren nach Anspruch 10, wobei der vorbestimmte Zustand für jede Phase der gleiche ist und jeder der vorbestimmten Zustände um den Versatz zwischen den Phasen versetzt ist.

12. Verfahren nach Anspruch 11, wobei das Überwachen der Wellenform das Überwachen eines Nulldurchgangs der Wellenform umfasst.

13. Verfahren nach Anspruch 12, wobei der vorbestimmte Zustand eine Zeitverzögerung nach dem Nulldurchgang der Wellenform ist, wobei die Zeitverzögerung bevorzugt zwischen 25% und 75% eines Halbzyklus der Wellenform beträgt.

14. Verfahren nach Anspruch 1, ferner umfassend:
Senden eines vierten Steuersignals zum Schließen des Festkörperschalters, nachdem die zweite Wellenform der elektrischen Wechselstromleistung den zweiten vorbestimmten Zustand erreicht hat.

15. Verfahren nach Anspruch 14,
wobei der Festkörperschalter (16) bei nachfolgenden Wellenformen nach 10 oder weniger Wellenformen geschlossen bleibt.

## Revendications

1. Procédé de commande d'un moteur électrique à courant alternatif AC (10), comprenant les étapes suivantes :
ouvrir un commutateur à semi-conducteurs (16) couplé entre une alimentation en courant alternatif (12) et le moteur électrique à courant alternatif (10), l'alimentation en courant alternatif (12) fournissant du courant électrique alternatif au moteur électrique à courant alternatif (10) pour faire tourner le moteur électrique à courant alternatif (10) lorsque le commutateur à semi-conducteurs (16) est fermé, et l'alimentation en courant alternatif (12) étant déconnectée du moteur électrique à courant alternatif (10) pour arrêter la rotation du moteur électrique à courant alternatif (10) lorsque le commutateur à semi-conducteurs (16) est ouvert ;
recevoir un premier signal de commande pour mettre en marche le moteur électrique à courant alternatif (10) ;
surveiller une forme d'onde de l'alimentation électrique en courant alternatif fournie par l'alimentation électrique en courant alternatif (12),
où la forme d'onde est une première forme d'onde ;
retarder la fermeture du commutateur à semi-conducteurs après avoir reçu le premier signal de commande jusqu'à ce que la forme d'onde de l'alimentation électrique en courant alternatif atteigne un état prédéterminé,
où l'état prédéterminé est un premier état prédéterminé ;
envoyer un deuxième signal de commande pour fermer le commutateur à semi-conducteurs (16) après que la forme d'onde de l'alimentation électrique en courant alternatif atteigne le premier état prédéterminé ;
envoyer un troisième signal de commande pour réouvrir le commutateur à semi-conducteurs après l'envoi du deuxième signal de commande ;
surveiller une deuxième forme d'onde de l'énergie électrique en courant alternatif fournie par l'alimentation électrique en courant alternatif (12) ; et
retarder la fermeture du commutateur à semi-conducteurs (16) jusqu'à ce que la deuxième forme d'onde de l'alimentation électrique en courant alternatif atteigne un deuxième état prédéterminé,
où le premier état prédéterminé et le deuxième état prédéterminé sont différents l'un de l'autre pour permettre un flux de courant plus important à travers le commutateur à semi-conducteurs pendant la deuxième forme d'onde que pendant la première forme d'onde.

2. Procédé selon la revendication 1, dans lequel la surveillance de la forme d'onde comprend la surveillance d'un passage par zéro de la forme d'onde.

3. Procédé selon la revendication 2, dans lequel l'état prédéterminé est un délai après le passage par zéro de la forme d'onde.

4. Procédé selon la revendication 3, dans lequel le délai est compris entre 25 % et 75 % d'un demi-cycle de la forme d'onde, de préférence où la forme d'onde est une forme d'onde de tension.

5. Procédé selon la revendication 1, dans lequel la forme d'onde est une forme d'onde de tension.

6. Procédé selon la revendication 1, dans lequel le commutateur à semi-conducteurs (16) est un contacteur de moteur électrique.

7. Procédé selon la revendication 6, dans lequel le courant traversant le contacteur de moteur électrique est limité dans un premier cycle de la forme d'onde à 10 fois un courant nominal de fonctionnement du moteur électrique à courant alternatif (10).

8. Procédé selon la revendication 1, dans lequel le courant traversant le commutateur à semi-conducteurs (16) est limité dans un premier cycle de la forme d'onde à 8 fois un courant de fonctionnement nominal du moteur électrique à courant alternatif (10).

9. Procédé selon la revendication 1, dans lequel l'alimentation électrique en courant alternatif (12) est un réseau électrique en courant alternatif ; ou
dans lequel le moteur électrique à courant alternatif (10) a un rendement d'au moins 85 %.

10. Procédé selon la revendication 1, dans lequel l'alimentation électrique en courant alternatif comprend une alimentation triphasée, et comprend au moins l'un du commutateur à semi-conducteurs (16) pour chaque phase, où la fermeture du commutateur à semi-conducteurs (16) pour chaque phase est retardée jusqu'à ce que la forme d'onde de la phase associée à chaque commutateur à semi-conducteurs (16) atteigne un état prédéterminé, et le deuxième signal est envoyé à chaque commutateur à semi-conducteurs après que la forme d'onde de la phase associée à chaque commutateur à semi-conducteurs a atteint l'état prédéterminé, le deuxième signal pour chacun des commutateurs (16) étant envoyé à des moments différents les uns par rapport aux autres de sorte que les commutateurs à semi-conducteurs (16) ne se ferment pas en même temps.

11. Procédé selon la revendication 10, dans lequel l'état prédéterminé est le même pour chaque phase, chacun des états prédéterminés étant décalé du décalage entre les phases.

12. Procédé selon la revendication 11, dans lequel la surveillance de la forme d'onde comprend la surveillance d'un passage par zéro de la forme d'onde.

13. Procédé selon la revendication 12, dans lequel l'état prédéterminé est un délai après le passage par zéro de la forme d'onde, de préférence dans lequel le délai est compris entre 25 % et 75 % d'un demi-cycle de la forme d'onde.

14. Procédé selon la revendication 1, comprenant en outre l'étape suivante :
envoyer un quatrième signal de commande pour fermer le commutateur à semi-conducteurs après que la deuxième forme d'onde de l'alimentation électrique en courant alternatif a atteint le deuxième état prédéterminé.

15. Procédé selon la revendication 14,
dans lequel le commutateur à semi-conducteurs (16) reste fermé pendant les formes d'onde suivantes après 10 formes d'onde ou moins.
